# EUROPEAN PATENT APPLICATION

(11) **EP 4 064 102 A2**
(43) Date of publication of application: **28.09.2022**
(21) Application number: 22163293.8
(22) Date of filing: 21.03.2022
(51) Int. Cl.: G06F 30/12, B23P 21/00, G06F 30/27

(54) **VIRTUAL REALITY TO ASSIGN OPERATION SEQUENCING ON AN ASSEMBLY LINE**

(30) Priority: 25.03.2021 US 202117212256
(71) Applicant: B/E Aerospace, Inc., Winston-Salem, NC 27105 (US)
(72) Inventor: TATE, Stephen H., Downpatrick (IE)
(74) Representative: Dehns

(57) **Abstract**

A system and method for designing an assembly line and optimising the layout before actually implementing the assembly line includes utilising an artificial intelligence, AI, machine learning algorithm to produce an initial assembly line layout based on sets of previous assembly lines, parts used, and space constraints. The initial assembly line layout is rendered in a virtual environment (200) to allow a user to examine and interact with the initial assembly line layout before it is actually implemented. Any changes made in the virtual environment are used to update the initial assembly line layout.

## Description

### BACKGROUND

Planning and designing a new assembly line, such as for aircraft seat production, purely from line configurations, operator task sequences, and production knowledge acquired from the production of previous designs is prone to suboptimal partitioning of the line into its various operation stations, suboptimal assignment of an operator task sequence and its associated set of components / parts to each assembly line station, and suboptimal physical positioning of the assembly line stations resulting in poor access or clearance between stations and parts benches. Existing assembly line design offers few mechanisms for correcting these deficiencies; where they are only discovered during product production, the only viable correction is to stop the production line completely and make piecemeal adjustments. Optimizing the design after implementation is often not viable.

### SUMMARY

In one aspect, embodiments of the inventive concepts disclosed herein are directed to a system and method for designing an assembly line and optimizing the layout before actually implementing the assembly line. An artificial intelligence (Al) machine learning algorithm produces an initial assembly line layout based on sets of previous assembly lines, parts used, and space constraints. The initial assembly line layout is rendered in a virtual environment to allow a user to examine and interact with the initial assembly line layout before it is actually implemented. Any changes made in the virtual environment are used to update the initial assembly line layout.

It is to be understood that both the foregoing general description and the following detailed description are exemplary and explanatory only and should not restrict the scope of the claims. The accompanying drawings, which are incorporated in and constitute a part of the specification, illustrate exemplary embodiments of the inventive concepts disclosed herein and together with the general description, serve to explain the principles.

### BRIEF DESCRIPTION OF THE DRAWINGS

The numerous advantages of the embodiments of the inventive concepts disclosed herein may be better understood by those skilled in the art by reference to the accompanying figures in which:
- FIG. 1: shows a block diagram of a system useful for implementing exemplary embodiments;
- FIG. 2: shows a virtual environmental view of an exemplary embodiment;
- FIG. 3: shows a flowchart of a method according to an exemplary embodiment;
- FIG. 4: shows a flowchart of a method according to an exemplary embodiment;
- FIG. 5: shows a flowchart of a method according to an exemplary embodiment;
- FIG. 6: shows a flowchart of a method according to an exemplary embodiment;

### DETAILED DESCRIPTION

Before explaining at least one embodiment of the inventive concepts disclosed herein in detail, it is to be understood that the inventive concepts are not limited in their application to the details of construction and the arrangement of the components or steps or methodologies set forth in the following description or illustrated in the drawings. In the following detailed description of embodiments of the instant inventive concepts, numerous specific details are set forth in order to provide a more thorough understanding of the inventive concepts. However, it will be apparent to one of ordinary skill in the art having the benefit of the instant disclosure that the inventive concepts disclosed herein may be practiced without these specific details. In other instances, well-known features may not be described in detail to avoid unnecessarily complicating the instant disclosure. The inventive concepts disclosed herein are capable of other embodiments or of being practiced or carried out in various ways. Also, it is to be understood that the phraseology and terminology employed herein is for the purpose of description and should not be regarded as limiting.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only, and should not be construed to limit the inventive concepts disclosed herein in any way unless expressly stated to the contrary.

Further, unless expressly stated to the contrary, "or" refers to an inclusive or and not to an exclusive or. For example, a condition A or B is satisfied by anyone of the following: A is true (or present) and B is false (or not present), A is false (or not present) and B is true (or present), and both A and B are true (or present).

In addition, use of the "a" or "an" are employed to describe elements and components of embodiments of the instant inventive concepts. This is done merely for convenience and to give a general sense of the inventive concepts, and "a" and "an" are intended to include one or at least one and the singular also includes the plural unless it is obvious that it is meant otherwise.

Finally, as used herein any reference to "one embodiment," or "some embodiments" means that a particular element, feature, structure, or characteristic described in connection with the embodiment is included in at least one embodiment of the inventive concepts disclosed herein. The appearances of the phrase "in some embodiments" in various places in the specification are not necessarily all referring to the same embodiment, and embodiments of the inventive concepts disclosed may include one or more of the features expressly described or inherently present herein, or any combination of sub-combination of two or more such features, along with any other features which may not necessarily be expressly described or inherently present in the instant disclosure.

Broadly, embodiments of the inventive concepts disclosed herein are directed to a system and method for designing an assembly line and optimizing the layout before actually implementing the assembly line. An artificial intelligence (Al) machine learning algorithm produces an initial assembly line layout based on sets of previous assembly lines, parts used, and space constraints. The initial assembly line layout is rendered in a virtual environment to allow a user to examine and interact with the initial assembly line layout before it is actually implemented. Any changes made in the virtual environment are used to update the initial assembly line layout.

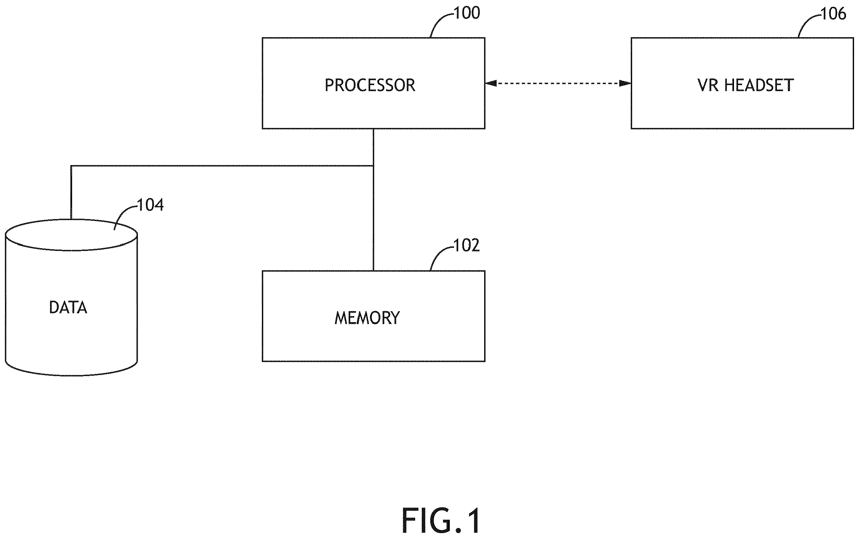

Referring to FIG. 1, a block diagram of a system useful for implementing exemplary embodiments is shown. The system includes a processor 100, memory 102 connected to the processor 100 for embodying processor executable code, a data storage element 104 connected to the processor 100 for storing assembly line specific data as more fully described herein, and a virtual reality (VR) headset 106 in data communication with the processor 100. The processor 100 is configured via processor executable code to implement an artificial intelligence (Al) or machine learning algorithm such as via a neural network to establish an initial assembly line design based on a set of initial conditions and / or constraints.

In at least one embodiment, Al, neural networks, or other machine learning algorithms are employed to receive a set of conditions such as available floor space, a list of components, and a design specification for the final product such as an aircraft seat. The Al / neural network is trained via sets of defined assembly line criteria for similar products to produce an initial assembly line layout as stored in the data storage element 104.

AI and machine learning in general, and neural networks in particular, employ processing layers organized in a feed forward architecture where neurons (nodes) only receive inputs from the previous layer and deliver outputs only to the following layer, or a recurrent architecture, or some combination thereof. Each layer defines an activation function, comprised of neuron propagation functions, such as a Hyperbolic tangent function, a linear output function, and/or a logistic function, or some combination thereof. AI and machine learning in general, and neural networks in particular, utilize supervised learning conducted during the design phase to establish weighting factors and activation functions for each node. During supervised training, a designer may adjust one or more input biases or synaptic weights of the nodes in one or more processing layers of the neural network according to a loss function that defines an expected performance. Alternatively, or in addition, the designer may utilize certain training data sets, categorized as selection data sets, to choose a predictive model for use by the neural networks.

During unsupervised training, the neural network adjusts one or more input biases or synaptic weights of the nodes in one or more processing layers according to an algorithm. In at least one embodiment, where the training data sets include both stable and unstable approaches, the training algorithm may comprise a first component to minimize disparity with approaches labeled "stable" and a second component to prevent close approximation with approaches labeled "unstable." A person skilled in the art may appreciate that maximizing disparity with unstable approaches may be undesirable until the neural network has been sufficiently trained or designed so as to define constraints of normal operation within which both stable and unstable approaches are conceivable. In at least one embodiment, training data sets may be categorized based on a defined level of stability or instability, and provided in ascending order of convergence such that the disparities between stable and unstable approaches diminish during training and necessary adjustments presumably become smaller over time according to first and second order deviations of the corresponding loss function. The loss function may define error according to mean square, root mean square, normalized square, a weighted square, or some combination thereof, where the gradient of the loss function may be calculated via backpropagation.

After an initial assembly line layout is established, the initial assembly line layout is rendered in a virtual environment on the VR headset 106. A user may examine and interact with the initial assembly line layout in the virtual environment. The processor 100 records any changes made by the user in the virtual environment and updates the initial assembly line layout according to those changes to produce an updated assembly line layout. The updated assembly line layout may then be communicated as necessary to implement the updated assembly line layout and, in at least one embodiment, added to the training set of defined assembly lines. In at least one embodiment, assignment or reassignment of parts to operation sequences are captured in an excel export and imported into an ERP system.

Changes made by the user may include changes to the relative or absolute spacing and orientation of operation stations, the relative or absolute spacing and orientation of parts benches, and any other features of the assembly line subject to manipulation. In at least one embodiment, every change may be analyzed with respect to the set of initial conditions and constraints to ensure no change made by a user violates any of those conditions and constraints; for example, any changes to the position of operation stations and parts benches must remain within the space established for the assembly line.

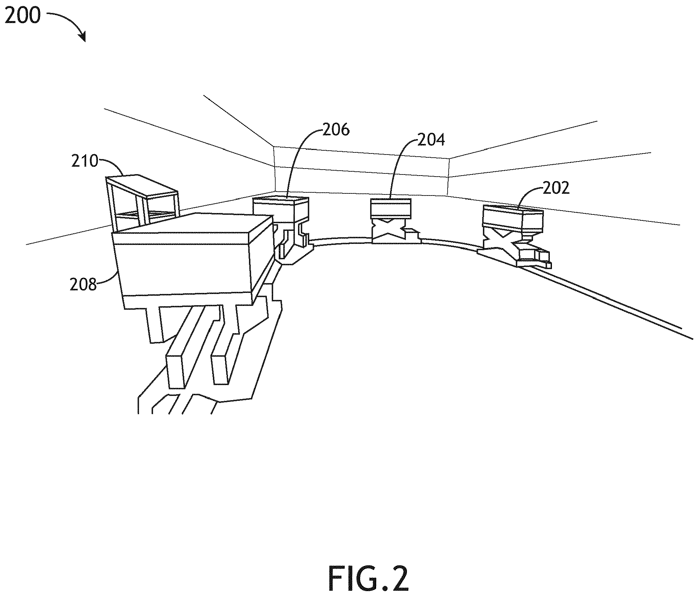

Referring to FIG. 2, a virtual environmental view of an exemplary embodiment is shown. The virtual environment 200, based on an initial assembly line layout that may be produced via an artificial intelligence, includes one or more operation stations 202, 204, 206, 208 and one or more parts benches 210. The operation stations 202, 204, 206, 208 and parts benches 210 are repositionable and reorientable within certain initial constraints such as the overall size of the available area and necessary clearances as defined by the corresponding operation.

In at least one embodiment, operation stations 202, 204, 206, 208 and parts benches 210 may be moved with respect to each other to alter the sequence of production operations. In at least one embodiment, each operating station 202, 204, 206, 208 may be associated with one or more corresponding parts benches 210 such that certain changes to an operating station 202, 204, 206, 208 are automatically reflected in the corresponding parts benches 210; for example, where an operating station 202, 204, 206, 208 is moved to alter the sequence of production, the corresponding parts benches 210 are automatically moved to accommodate the change in sequence.

In at least one embodiment, a virtual production sequence may be rendered to allow the user to more easily visualize the production process and identify any issues with placement or clearance.

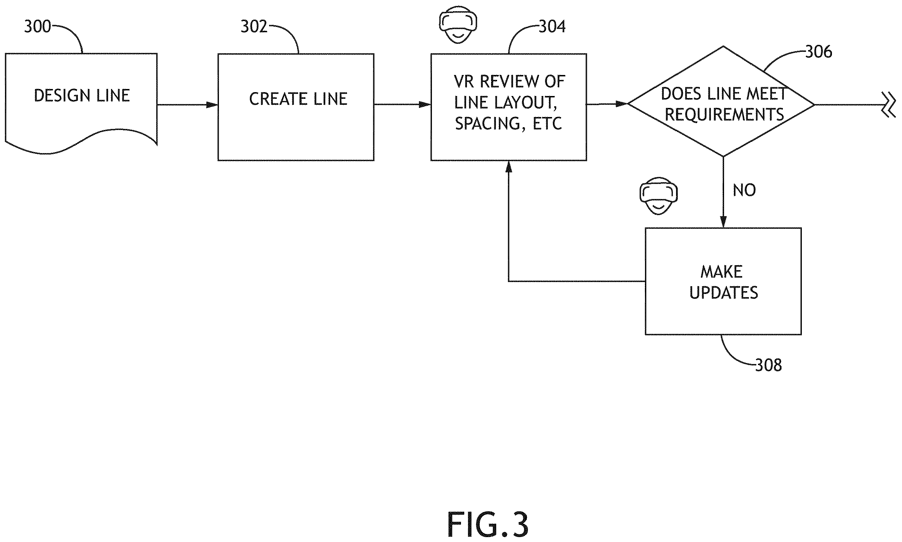

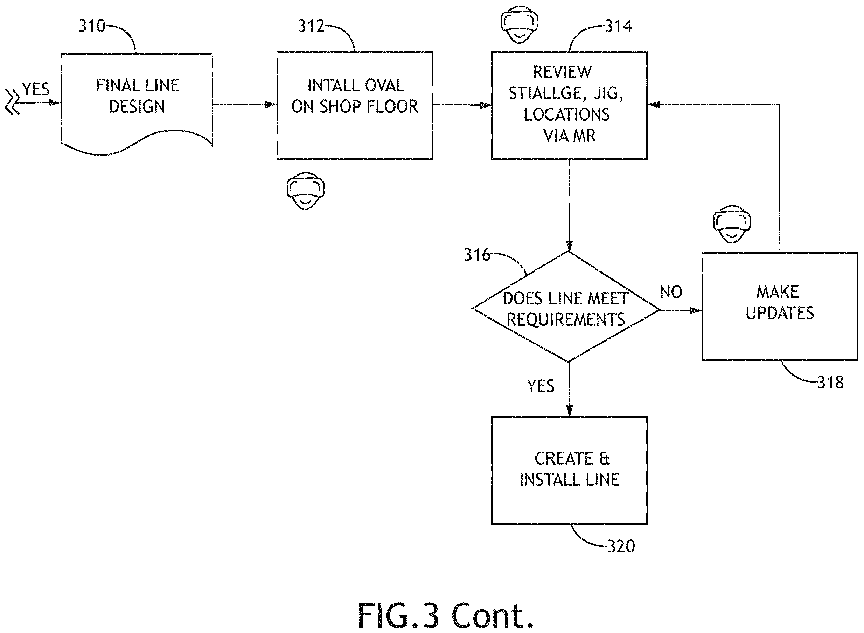

Referring to FIG. 3, a flowchart of a method according to an exemplary embodiment is shown. During an assembly line design process, an initial assembly line layout is designed 300, including takt time, number of operation sequences, stillages, monitors, etc.; either by a user or a trained Al. The initial assembly line layout is further developed 302 to include oval, stillages, scissor benches, stands, computer desks, and any other items available from a standard item catalogue; and the operation sequence is linked to kit boxes. The initial assembly line layout is then transferred to an appropriate VR system for rendering in a virtual environment on a VR headset.

Using the VR headset, a user reviews 304 the initial assembly line layout with all components included. Components may be moved and manipulated at the discretion of the user. Either the rendering processor or a separate processor reviews any use-initiated changes to determine 306 if production can be carried out safely and meet customer demands. In at least one embodiment, a product, such as an aircraft seat, will be rendered in place at each operation station to assess if space is adequate for the product, including appropriate clearances for rotation. If the reviewing processor identifies a conflict, a corrective update is applied 308 and the updated assembly line is re-rendered for further review.

If the updated assembly line layout is determined 306 to meet all requirements, the layout is finalized 310 into a standardized format to place into production. In at least one embodiment, the finalized layout may include dimensions and a 2D printable rendering. The finalized design may be used to install 312 the designed assembly in the allocated space such as a shop floor. During installation, or after the initial installation steps (such as installation of the oval and scissor benches), an augmented reality (AR) system may receive a 3D rendering of the finalized assembly line layout and a user may review 314 the actual layout in place as compared to the design. In at least one embodiment, a processor may determine 316 if the initial installation steps conform to the finalized design and if the installation is adequate to meet production line specifications. If not, the user or processor may apply 318 one or more updates, and the updates are applied to the AR rendered environment for further review 314. When all requirements are satisfied, the assembly line may be completed 320, including stillages, work stations, monitors, etc.

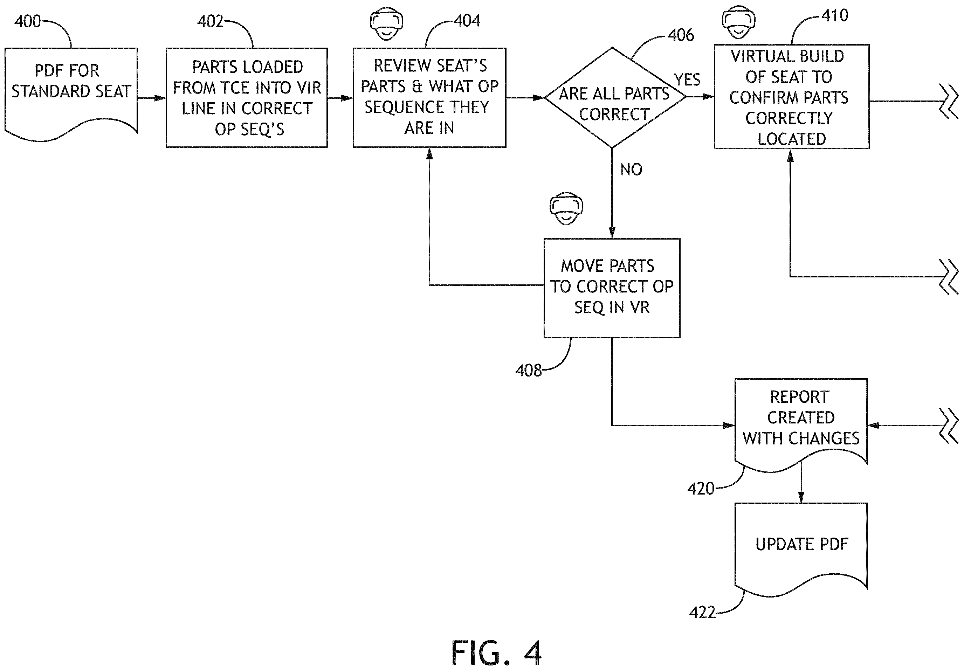

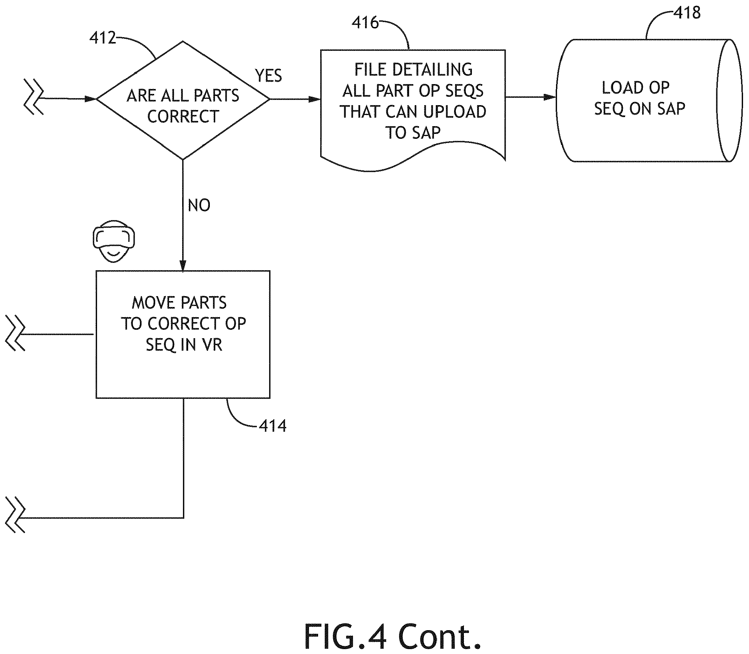

Referring to FIG. 4, a flowchart of a method according to an exemplary embodiment is shown. A process flow diagram is created 400, including operation sequencing information for individual piece parts of the full assembly. In a rendered virtual environment, parts identified in the process flow diagram are imported 402 into the virtual environment and allocated to the appropriate virtual kit boxes for the relevant operation sequence. A user may then review 404 the allocation of parts via a VR headset to determine 406 if the correct parts (including part sizes) are in the correct kit boxes, and the disposition of the kit boxes and overhang of parts is correct. If not, the user may reposition 408 any kit boxes as necessary and review 404 such new disposition.

When the parts have been verified, the user may complete 410 a virtual build of the product to confirm each kit box is correct. In at least one embodiment, a sequential build; alternatively, a full assembly may be executed with parts highlighted according to the kit box selected. The user again has the opportunity to determine 412 if all parts are correctly positioned. If not, the user may again reposition 414 parts and review 410 the resulting re-rendering in the context of the actual build operation.

When the user is satisfied, all changes are recorded and reported 420 to correct the assembly line layout, and the process flow diagram is updated 422 accordingly. In at least one embodiment, once the parts have been reviewed and confirmed to be in the correct location, that information is transferred 416 to an SAP report / workbook. SAP may create 418 the operation sequence for individual parts.

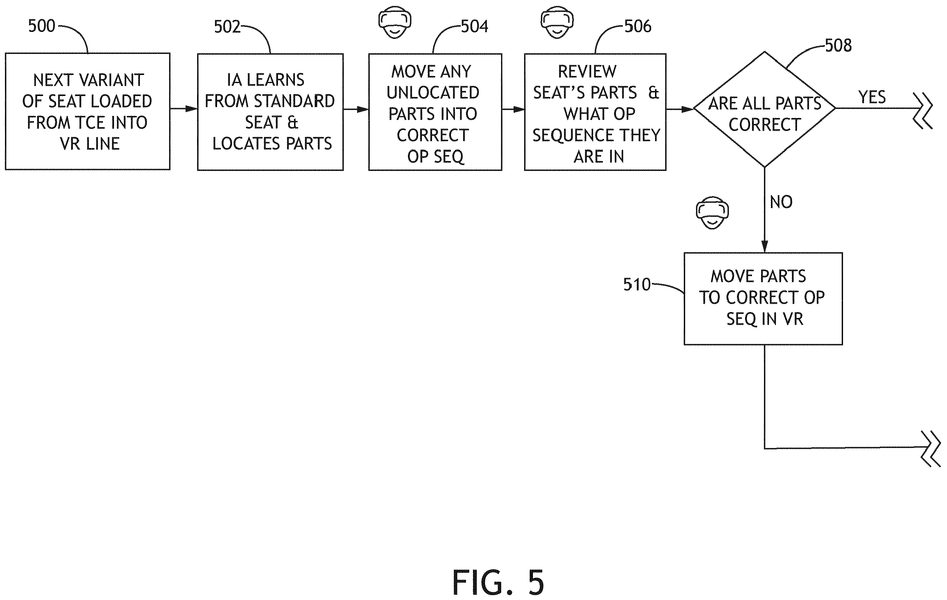

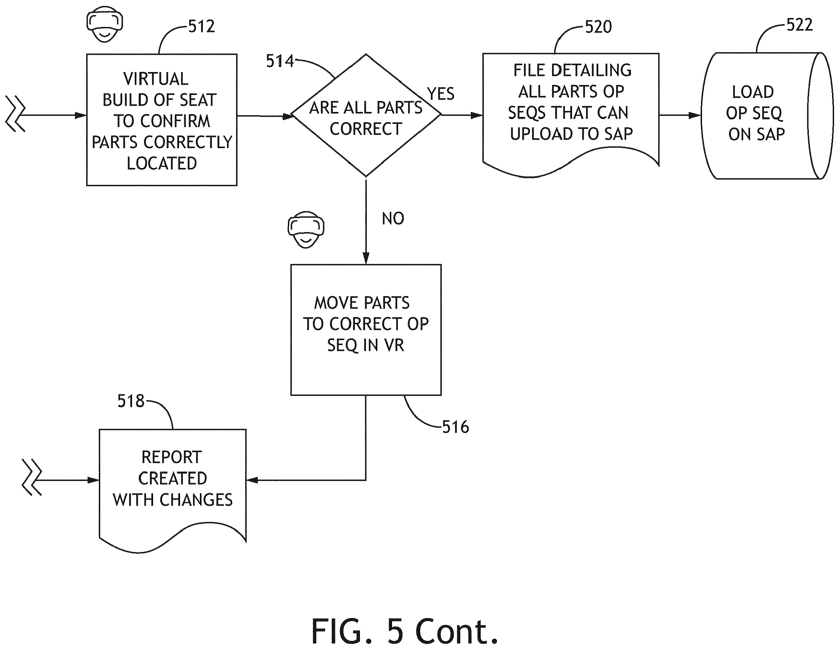

Referring to FIG. 5, a flowchart of a method according to an exemplary embodiment is shown. It at least one embodiment, products of the assembly line may include variants; for example, the assembly line may be used to produce a standard aircraft seat and variants. Once the assembly line is verified for the standard product, the next variant (where the product is an aircraft seat, variants may include OB, AFT, FWD, etc.) will be uploaded 500 to the virtual environment. An AI process may use standard part allocation and locate 502 parts to the correct kit box for the relevant operation sequence. Such allocation may include the same parts being automatically allocated to same op sequence; similar parts in shape being automatically allocated to the same op sequence; and new parts that are different in number and shape being automatically allocated to a central bin for manual allocation in the virtual environment via the VR headset.

The user may place 504 any parts that cannot be automatically positioned, including new parts by lifting and dropping in the relevant kit box. The user may then review 506 the allocation of parts via a VR headset to determine 508 if the correct parts (including part sizes) are in the correct kit boxes, and the disposition of the kit boxes and overhang of parts is correct. If not, the user may reposition 510 any kit boxes as necessary. Such repositioning is recorded 518 in the assembly line layout, specifically associated with the particular variant, and reported electronically for implementation.

When the parts have been verified, the user may complete 512 a virtual build of the product to confirm each kit box is correct. In at least one embodiment, a sequential build; alternatively, a full assembly may be executed with parts highlighted according to the kit box selected. The user again has the opportunity to determine 514 if all parts are correctly positioned. If not, the user may again reposition 516 parts with the changes recorded 518 in the assembly line layout, specifically associated with the particular variant, and reported electronically for implementation.

When the user is satisfied, all changes are recorded and reported for further review and to correct the assembly line layout, and the process flow diagram is updated accordingly. In at least one embodiment, once the parts have been reviewed and confirmed to be in the correct location, that information is transferred 520 to an SAP report / workbook. SAP may create 522 the operation sequence for individual parts.

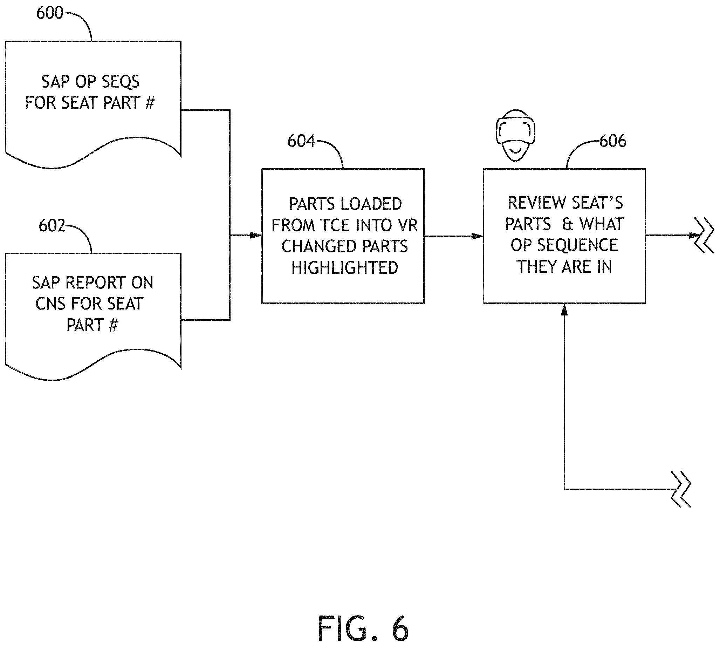

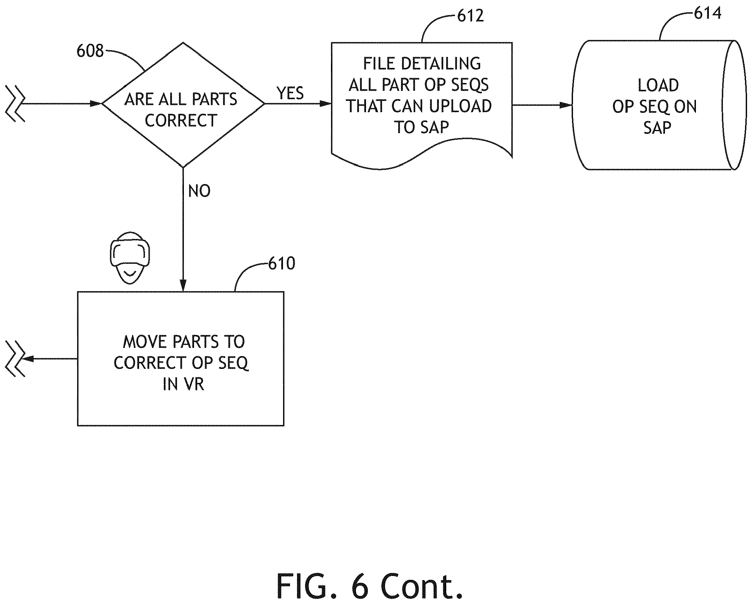

Referring to FIG. 6, a flowchart of a method according to an exemplary embodiment is shown. During an assembly line layout review, SAP provides 600 operation sequences for a given part number and generates 600 a report of changes that have a down-stream effect on other operation sequences. Selected time frames and parts may be loaded 604 into a virtual environment to show changes that impact down-stream operation sequences. These parts may be automatically reallocated to correct operation sequence or sent to a holding area for manual allocation. A user may position and unallocated parts and then review 606 the allocation of parts via a VR headset to determine 608 if the correct parts (including part sizes) are in the correct kit boxes, and the disposition of the kit boxes and overhang of parts is correct. If not, the user may reposition 610 any kit boxes as necessary and review 606 such new disposition.

When the parts have been verified, that information is transferred 612 to an SAP report / workbook. SAP may create 614 the operation sequence for individual parts.

Embodiments of the present disclosure enable designing an assembly line in Virtual Reality before committing to building the physical line, allowing for the assembly line to be built in a virtual environment mimicking that of a physical one all within the space assigned. This enables correct positioning of the line stations within the space available ensuring good access and clearance between stations and assembly work benches.

Embodiments allow for assignment of parts to operation sequences with any assignment / reassignment captured in an excel export system. The Assembly line may be built in a virtual environment and parts imported, where they can be virtually lifted and assigned to the correct position. Currently all line designs and operation sequencing is done based on previous knowledge acquired from the production of previous product designs and is prone to poor positioning of stations, incorrect operation sequence assigned, and suboptimal physical positioning of the assembly line. All operation sequencing is currently completed with thousands of parts, typically new, that must be manually assigned to a location on the assembly line with limited information.

It is believed that the inventive concepts disclosed herein and many of their attendant advantages will be understood by the foregoing description of embodiments of the inventive concepts disclosed, and it will be apparent that various changes may be made in the form, construction, and arrangement of the components thereof without departing from the broad scope of the inventive concepts disclosed herein or without sacrificing all of their material advantages; and individual features from various embodiments may be combined to arrive at other embodiments. The form herein before described being merely an explanatory embodiment thereof, it is the intention of the following claims to encompass and include such changes. Furthermore, any of the features disclosed in relation to any of the individual embodiments may be incorporated into any other embodiment.

## Claims

1. A computer apparatus comprising:
a virtual reality, VR, headset (106); and
at least one processor (100) in data communication with the virtual reality headset and a memory storing processor executable code for configuring the at least one processor (100) to:
receive an initial assembly line layout comprising one or more operation stations (202, 204, 206, 208) and one or more parts benches (210);
render the initial assembly line layout in a virtual environment (200);
identify a user-initiated change in a position or an orientation of one or more of the operation stations or parts benches; and
update the initial assembly line layout to reflect the user-initiated change.

2. The computer apparatus of Claim 1, wherein the at least one processor (100) is further configured to instantiate an artificial intelligence, Al, process configured to:
receive a set of assembly line parameters; and
produce the initial assembly line layout via a neural network.

3. The computer apparatus of Claim 2, wherein the AI process is further configured to include the updated initial assembly line layout in a training data set for the neural network.

4. The computer apparatus of Claim 2 or 3, wherein the assembly line parameters include an available space, a parts list, and a product classification.

5. The computer apparatus of Claim 2, 3 or 4, wherein the at least one processor (100) is further configured to verify that the user-initiated change does not violate any of the set of assembly line parameters.

6. The computer apparatus of any preceding Claim, wherein the at least one processor (100) is further configured to render an assembly sequence.

7. The computer apparatus of any preceding Claim, wherein the at least one processor (100) is further configured to associate at least one operating station with one or more parts benches such that a user-initiated change applied to the at least one operating station is applied to the associated parts benches.

8. A method for designing an assembly line comprising:
receiving an initial assembly line layout comprising one or more operation stations and one or more parts benches;
rendering the initial assembly line layout in a virtual environment;
identifying a user-initiated change in a position or an orientation of one or more of the operation stations or parts benches; and
updating the initial assembly line layout to reflect the user-initiated change.

9. The method of Claim 8, further comprising instantiating an artificial intelligence, AI, process configured for:
receiving a set of assembly line parameters; and
producing the initial assembly line layout via a neural network.

10. The method of Claim 9, wherein the AI process is further configured for including the updated initial assembly line layout in a training data set for the neural network; and/or wherein the assembly line parameters include an available space, a parts list, and a product classification; and/or further comprising verifying that the user-initiated change does not violate any of the set of assembly line parameters.

11. The method of Claim 8, 9 or 10, further comprising rendering an assembly sequence.

12. A system for designing aircraft seat assembly lines comprising:
a virtual reality, VR, headset (106); and
at least one processor (100) in data communication with the virtual reality headset and a memory storing processor executable code for configuring the at least one processor to:
receive an initial assembly line layout comprising one or more operation stations (202, 204, 206, 208) and one or more parts benches (210);
render the initial assembly line layout in a virtual environment (200);
identify a user-initiated change in a position or an orientation of one or more of the operation stations or parts benches; and
update the initial assembly line layout to reflect the user-initiated change.

13. The system of Claim 12, wherein the at least one processor (100) is further configured to instantiate an artificial intelligence, Al, process configured to:
receive a set of assembly line parameters; and
produce the initial assembly line layout via a neural network.

14. The system of Claim 13, wherein the AI process is further configured to include the updated initial assembly line layout in a training data set for the neural network; and/or
wherein the assembly line parameters include an available space, a parts list, and a product classification; and/or
wherein the at least one processor is further configured to verify that the user-initiated change does not violate any of the set of assembly line parameters.

15. The system of Claim 12, 13 or 14, wherein the at least one processor (100) is further configured to render an assembly sequence; and/or
wherein the at least one processor (100) is further configured to associate at least one operating station with one or more parts benches such that a user-initiated change applied to the at least one operating station is applied to the associated parts benches.
